(19) Europäisches Patentamt

European Patent Office

Office européen des brevets

(11) EP 1 359 695 A2

(12) EUROPÄISCHE PATENTANMELDUNG

(43) Veröffentlichungstag:
05.11.2003 Patentblatt 2003/45

(51) Int Cl.⁷: H04L 1/00

(21) Anmeldenummer: 03008220.0

(22) Anmeldetag: 09.04.2003

(84) Benannte Vertragsstaaten:
AT BE BG CH CY CZ DE DK EE ES FI FR GB GR
HU IE IT LI LU MC NL PT RO SE SI SK TR
Benannte Erstreckungsstaaten:
AL LT LV MK

(30) Priorität: 02.05.2002 DE 10219701

(71) Anmelder: Astrium GmbH
81663 München (DE)

(72) Erfinder: Trautenberg, Hans L., Dr.
92318 Neumarkt (DE)

(74) Vertreter: Ulrich, Thomas
EADS Deutschland GmbH
Patentabteilung
LG-SP
81663 München (DE)

(54) **Verfahren zum Interleaving von Navigationsdaten**

(57) Beschrieben wird ein Verfahren, ein Satelliten-Navigationssystem und ein Teilnehmer-Endgerät zur Bereitstellung und Übertragung von Navigationsdaten in einem Navigationssystem durch Übertragung von mehreren Navigationsdatenblocks von einer Navigationsdaten-Sendeeinrichtung an Navigations-Endgeräte. Vor der Übertragung der Navigationsdaten an die Navigations-Endgeräte erfolgt ein Interleaving von mindestens zwei Navigationsdatenblocks.

Fig. 1

**Beschreibung**

US 6,101,1778 beschreibt ein Verfahren zur Übertragung von Navigationsdaten an Navigations-Endgeräte, bei dem von mehreren Navigationsdaten-Sendeeinrichtungen, hier von Navigationssatelliten und Pseudolites, Navigationsdaten ausgesendet werden, wobei ein Interleaving der Navigationsdaten verschiedener Navigations-Sendeeinrichtungen mit einem TDMA-Verfahren erfolgt.

Durch ein solches Verfahren nach dem Stand der Technik wird jedoch lediglich erreicht, dass sich die gesendeten Navigationsdaten unterschiedlicher Navigationsdaten-Sendeeinrichtungen möglichst nicht gegenseitig stören. Eine Optimierung der Datenübertragung einer einzelnen Navigationsdaten-Sendeeinrichtung ist dadurch jedoch nicht möglich.

Aufgabe der vorliegenden Erfindung ist es, eine Möglichkeit bereitzustellen, die eine Optimierung der Übertragung von Navigationsdaten von einer Navigationsdaten-Sendeeinrichtung an Navigations-Endgeräte erlaubt.

Diese Aufgabe wird gelöst durch die Merkmale der Ansprüche 1 und 14. Weitere Gegenstände der vorliegenden Erfindung sind ein Teilnehmer-Endgerät nach Anspruch 16, ein Computer-Programm nach Anspruch 17 und ein Computer-Programm-Produkt nach Anspruch 18. Die Erfindung ist grundsätzlich für alle Arten von Navigationssystemen anwendbar, insbesondere für Satelliten-Navigationssysteme.

Ein erster Gegenstand der Erfindung ist ein Verfahren zur Bereitstellung und Übertragung von Navigationsdaten in einem Navigationssystem durch Übertragung von mehreren Navigationsdatenblocks von einer Navigationsdaten-Sendeeinrichtung an Navigations-Endgeräte. Gemäß der vorliegenden Erfindung ist vorgesehen, dass vor der Übertragung der Navigationsdaten an die Navigations-Endgeräte ein Interleaving von mindestens zwei Navigationsdatenblocks erfolgt. Als Interleaving wird hier grundsätzlich jede Art der Aufteilung und Neugruppierung der Daten der einzelnen Navigationsdatenblocks erfolgt, wobei Daten unterschiedlicher Navigationsdatenblocks zu einem neuen Datenpacket zusammengefügt werden. Der Vorteil des Interleaving ist, dass die Daten eines Datenblocks auf mehrere Datenpakete verteilt werden können und so die einzelnen Daten des Datenblocks bei einer Datenübertragung separiert werden können. Wird bei einer Datenübertragung ein Datenpaket fehlerhaft übertragen, so gehen nicht alle Daten eines Datenblocks verloren, sondern nur ein Teil des Datenblocks. Der verloren gegangene Teil kann dann eventuell aus den übrigen Daten des Datenblocks, die in anderen Datenpaketen übertragen wurden, rekonstruiert werden.

Es kann lediglich eine Navigationsdaten-Sendeeinrichtung des Navigationssystems ein hier beschriebenes erfindungsgemäßes Verfahren durchführen oder es können auch mehrere oder alle Navigationsdaten-Sendeeinrichtungen des Navigationssystems ein solches Verfahren durchführen und auch entsprechend ausgebildet sein.

Der Umfang der Daten, über die ein Interleaving durchgeführt wird, kann durch den Dateninhalt eines Datenrahmens (Frame) definiert werden, der letztlich an die Navigations-Endgeräte übertragen wird. Ein solcher Datenrahmen ist in der Regel zumindest definiert durch Signalisierungsdaten (Header) und Nutzdaten, wobei die Signalisierungsdaten zumindest Identifizierungsdaten zur Identifizierung des Datenrahmens enthalten. Der Umfang der Daten, über die ein Interleaving durchgeführt wird, kann aber auch durch eine vorgegebene Sendezeit für einen der Navigationsdatenblocks festgelegt werden. Eine typische Sendezeit in Satelliten-Navigationssystemen für Navigationsdatenblocks, die Navigationsnachrichten enthalten, ist beispielsweise eine Sekunde.

Zum Interleaving kann insbesondere für jede Dateneinheit der Navigationsdatenblocks mit Hilfe eines Algorithmus ein Sendezeitpunkt festgelegt werden, wobei die Abfolge der Sendezeitpunkte von der ursprünglichen Abfolge der Dateneinheiten innerhalb der Navigationsdatenblocks abweicht. Es wird damit also eine Aussendung der einzelnen Dateneinheiten der Navigationsdatenblocks bewirkt, in der die Abfolge der Dateneinheiten nicht mehr der ursprünglichen Abfolge der Dateneinheiten in den Navigationsdatenblocks entspricht. Die Bedeutung der Dateneinheiten wird im folgenden noch definiert.

Liegt der Fall vor, dass in der gleichen Zeit, in der ein zeitunkritischer Navigationsdatenblock gesendet werden soll, auch k zeitkritische Navigationsdatenblocks gesendet werden sollen mit k= 2, 3, 4..., so kann der Algorithmus derart ausgebildet sein, dass zur Übertragung der k zeitkritischen Navigationsdatenblocks mit k= 2, 3, 4, ... und des einen zeitunkritischen Navigationsdatenblocks die Sendezeitpunkte der Dateneinheiten eines jeden zeitkritischen Navigationsdatenblocks jeweils in einem Bruchteil 1/k der Sendezeit des zeitunkritischen Navigationsdatenblocks festgelegt werden. Ist beispielsweise eine Sendezeit von einer Sekunde für einen zeitunkritischen Navigationsdatenblock vorgesehen und sollen in der gleichen Zeit 2 zeitkritische Navigationsdatenblocks gesendet werden, so ist der Algorithmus derart ausgebildet, dass die erste zeitkritische Nachricht in der ersten Hälfte der Sendezeit, also in der ersten ½-Sekunde gesendet und die zweite zeitkritische Nachricht in der zweiten Hälfte der Sendezeit, also in der zweiten ½-Sekunde gesendet. Die Bedeutung von zeitkritischen und zeitunkritischen Navigationsdatenblocks wird im folgenden noch definiert.

Ein Vorteil dieser Weiterbildung ist, dass die zeitkritischen Navigationsdatenblocks bereits in einem Bruchteil 1/k der Sendezeit des zeitunkritischen Navigationsdatenblocks komplett empfangen und im Endgerät verarbeitet werden können. Auch kann eine schnellere Aussendung der zeitkritischen Navigationsdatenblocks erfolgen, da bereits nach dem vorliegen des ersten zeitkritischen Navigationsdatenblocks mit der Aussendung der Daten begonnen werden kann, denn der zweite zeitkritischen Navigationsdatenblock muss erst in dem zweiten Bruchteil 1/k der Sendezeit zur Aussendung vorliegen. Analoges gilt für weitere zeitkritischen Navigationsdatenblocks.

Zur Durchführung des Interleaving können die Navigationsdatenblocks in gleiche Pakete mit indizierten Datenadressen aufgeteilt werden. Ein Interleaving kann dann durch aufeinanderfolgende Übertragung jeweils einer Dateneinheit eines Paketes erfolgen. Es wird also beispielsweise nach der Aufteilung der Daten der Navigationsdatenblocks auf die Pakete eine beliebige erste Dateneinheit des ersten Pakets gesendet, dann eine beliebige erste Dateneinheit des zweiten Pakets, dann eine beliebige erste Dateneinheit des dritten Pakets usw. bis zum letzten Paket. Dann wird eine zweite Dateneinheit des ersten Pakets gesendet, dann eine zweite Dateneinheit des zweiten Pakets usw. bis zum letzten Paket. Dieses Verfahren wird bis zur letzten Dateneinheit eines jeden Pakets fortgesetzt.

Im vorgenannten Beispiel wird von einer beliebigen Reihenfolge der Aussendung der Dateneinheiten pro Paket ausgegangen. Es kann aber auch eine Aussendung der Dateneinheiten pro Paket entsprechend der Indizierung der Datenadressen des Pakets erfolgen. So kann vorgesehen werden, dass zunächst nacheinander die Dateneinheiten aller Pakete mit der niedrigsten oder höchsten Datenadresse gesendet werden und dann die nacheinander die Dateneinheiten aller Pakete mit der nächsthöheren oder nächstniedrigeren Datenadresse gesendet werden. Stellt man die Pakete in Form von Spalten nebeneinander dar, so dass die Gesamtheit der Pakete eine Matrix bildet, dann entspricht diese Art der Aussendung einer zeilenweisen Aussendung der Dateneinheiten der Pakete.

Indizierte Datenadressen bedeutet dabei, dass korrespondierende Datenadressen der einzelnen Datenpakete für das Datenübertragungssystem über die Adressen erkennbar sind, d.h. dass insbesondere Anfang und Ende der Datenpakete ermittelbar sind und dass eine Reihenfolge der Daten innerhalb der Datenpakete definiert ist. Die Art der Indizierung und Adressierung kann grundsätzlich frei in geeigneter Weise gewählt werden.

Eine Weiterbildung der Erfindung sieht vor, dass mindestens eine erste Gruppe von Paketen für Navigationsdatenblocks mit zeitkritischen Navigationsdaten reserviert wird und mindestens eine zweite Gruppe von Paketen für Navigationsdatenblocks mit zeitunkritischen Navigationsdaten reserviert wird. Es werden also nicht alle Arten von Navigationsdaten gleichermaßen auf Datenpakete aufgeteilt, sondern es wird dabei nach der Bedeutung der Navigationsdaten, speziell nach zeitkritischen Aspekten, unterschieden. Damit wird ein unterschiedliche Behandlung von zeitkritischen und zeitunkritischen Navigationsdaten im Rahmen des Interleaving möglich, die Vorteile für die Weiterverarbeitung von Navigationsdaten bietet, wie im weiteren noch ausgeführt wird. Als zeitkritische Daten sind solche Daten zu verstehen, die einen sicheren Betrieb oder für bestimmte Anwendungen in den Navigations-Endgeräten möglichst umgehend an die Endgeräte übertragen werden müssen. Typische Zeiträume sind hier unter einer Sekunde. Zeitunkritische Daten sind dagegen Daten, die das Endgerät zwar für den Betrieb oder bestimmte Anwendungen benötigt, die aber auch mit einer gewissen Verzögerung beim Endgerät ankommen können, ohne dass der Betrieb des Endgerätes wesentlich gestört wird. Das Verhältnis der Zahlen der Pakete, die für zeitkritische und zeitunkritische Daten reserviert werden, wird bevorzugt bestimmt durch das Verhältnis der Datenmengen der zeitkritischen Daten und zeitunkritischen Daten. Beträgt die Datenmenge der zeitkritischen Daten ein Viertel bzw. die Hälfte der Datenmenge der zeitunkritischen Daten, so wird ein Viertel bzw. die Hälfte der Pakete für die zeitkritischen Daten reserviert, der Rest für die zeitunkritischen Daten.

Insbesondere kann vorgesehen werden, dass als zeitkritische Daten Statusnachrichten übertragen werden und als zeitunkritische Navigationsdaten Navigations-Nutzdaten übertragen werden, wobei die Navigations-Nutzdaten unmittelbar zur Positionsbestimmung seitens der Navigations-Endgeräte verwendet werden. Als Statusinformationen können beispielsweise Identifikationsdaten von Systemkomponenten, Versionsdaten von bestimmter Software oder auch Verkehrsinformationen für Land-, Wasser- oder Luftverkehr oder auch sonstige Arten von Statusinformationen übertragen werden.

Eine wichtige Art von Statusinformationen stellen Integritätsnachrichten betreffend Navigationsdaten-Sendeeinrichtungen des Navigationssystems dar. Diese können mit einem erfindungsgemäßen Interleaving-Verfahren einem Interleaving mit weiteren Navigationsdaten unterzogen werden. Die Übertragung der Navigationsdaten erfolgt bevorzugt durch einen Navigationssatelliten eines Satelliten-Navigationssystems. Als Integritätsnachrichten werden Nachrichten über die eigene Integrität des übertragenden Navigationssatelliten, oder über die Integrität einer ausgewählten Gruppe von Navigationssatelliten oder über die Integrität aller Navigationssatelliten eines Satelliten-Navigationssystems übertragen, zu dem der übertragende Navigationssatellit gehört. Alternativ oder zusätzlich kann vorgesehen werden, dass als Integritätsnachrichten Nachrichten über die Integrität von Navigationssatelliten anderer Satelliten-Navigationssyteme übertragen werden.

Bei einem speziellen Verfahren des Interleavings von zeitkritischen und zeitunkritischen Daten wird vorgesehen, dass

- alle Pakete eine Länge von n Dateneinheiten aufweisen,
- Pakete der ersten Gruppe von Paketen mit n/k, k=2, 3, 4, 5... Dateneinheiten eines Navigationsdatenblocks zeitkritischer Daten gefüllt werden und
- Pakete der zweiten Gruppe von Paketen mit n Dateneinheiten eines Navigationsdatenblocks zeitunkritischer Daten gefüllt werden.

Alle Datenpakete besitzen also die gleiche Länge. Als Dateneinheit kann beispielsweise ein Bit, ein Byte oder ein sonstiges, definiertes Datensymbol mit definierter Symbollänge vorgesehen werden. Die Pakete der zweiten Gruppe werden einfach mit den zeitunkritischen Daten der entsprechen Navigationsdatenblocks komplett aufgefüllt. Ist das Ende eines Navigationsdatenblocks mit zeitunkritischen Daten erreicht, so wird das Auffüllen der Pakete, welche für zeitunkritische Daten reserviert sind, mit dem nächsten Navigationsdatenblock zeitunkritischer Daten fortgesetzt.

Zeitkritische Daten werden jedoch anders behandelt: Es werden die für zeitkritische Daten reservierten Pakete nicht bis zur vollen Länge n mit den Daten zeitkritischer Datenblocks gefüllt, sondern es werden nur n/k Dateneinheiten eines Pakets mit Daten eines bestimmten Datenblocks gefüllt, im einfachsten Fall nur die erste Hälfte des Pakets. Der Dateninhalt des Datenblocks mit zeitkritischen Daten wird damit auf jeweils die erste Hälfte mehrerer Pakete verteilt. Dies bedeutet aber einen besonderen Vorteil: Durch das Interleaving werden die Dateninhalte der Pakete so übertragen, dass zunächst nacheinander alle Dateneinheiten übertragen werden, die am Anfang der Pakete stehen. Danach werden nacheinander alle Dateneinheiten übertragen, die an zweiter Stelle der Pakete stehen. Dies wird fortgeführt, bis das Ende der Pakete erreicht ist. Man kann leicht erkennen, dass ein Datenblock, der jeweils auf die erste Hälfte mehrerer Pakete aufgeteilt wurde, bereits nach der Hälfte der Zeit, die zur Übertragung aller Daten aller Pakete erforderlich ist, komplett übertragen wurde. Gleiches gilt für den allgemeinen Fall von n/k Dateneinheiten mit k=2, 3, 4.... Durch dieses Verfahren können also zeitkritische Daten sehr schnell komplett übertragen werde und trotzdem einem Interleaving unterzogen werden. Die ganze Zahl k kann grundsätzlich frei definiert werden. Sie entspricht aber bevorzugt der Zahl an Datenblocks mit zeitkritischen Daten, die in einer bestimmten Zeiteinheit übertragen werden müssen.

Bevorzugt wird vorgesehen, dass die Datenmenge der zeitkritischen Daten maximal die Hälfte, idealerweise maximal ein Viertel der Datenmenge der zeitunkritischen Daten beträgt. Damit wird die Effektivität des Verfahrens sichergestellt.

Ein weiterer Gegenstand der vorliegenden Erfindung ist ein Satelliten-Navigationssystem mit Navigationssatelliten, welche einerseits Einrichtungen zur Bereitstellung von Navigationsdaten in Form von mehreren Navigationsdatenblocks und andererseits Einrichtungen zur Übertragung von Daten an Navigations-Endgeräte aufweisen. Jeder Navigationssatellit weist entsprechend der vorliegenden Erfindung eine Einrichtung zum Interleaving von mindestens zwei Navigationsdatenblocks vor der Übertragung der Navigationsdaten an die Navigations-Endgeräte auf.

Die Einrichtung zum Interleaving kann insbesondere so weiter ausgebildet sein, dass sie zur Durchführung einzelner oder aller Schritte eines Interleaving-Verfahrens geeignet ist, wie es vorstehend beschrieben wurde. Die Einrichtung zum Interleaving ist dann an die entsprechenden Schritte des Interleaving-Verfahrens geeignet angepasst.

Ein weiterer Gegenstand der vorliegenden Erfindung ist ein Teilnehmer-Endgerät für ein Satelliten-Navigationssystem. Gemäß der Erfindung weist das Teilnehmer-Endgerät eine Einrichtung zur Rekonstruktion von Navigationsdatenblocks auf, welche vom Teilnehmer-Endgerät durch eine Empfangseinrichtung von mindestens einem Navigationssatelliten empfangen wurden und welche vor dem Empfang einem Interleaving nach einem vorstehend beschriebenen Verfahren unterzogen wurden. Die entsprechende Einrichtung des Teilnehmer-Endgerätes ist also dazu ausgebildet, die Navigationsdaten in der oben beschriebenen Form zu erkennen und aus diesen durch ein dem Interleaving komplementäres De-Interleaving wieder die ursprünglichen Navigationsdatenblocks zu rekonstruieren.

Ein weiterer Gegenstand der vorliegenden Erfindung ist ein Computer-Programm zur Verarbeitung von Navigationsdaten eines Satelliten-Navigationssystems, welche nach einem vorstehend beschriebenen Verfahren einem Interleaving unterzogen wurden, wobei das Computer-Programm für ein Zusammenwirken mit Einrichtungen eines vorgenannten Teilnehmer-Endgerätes ausgebildet ist. Das Computer-Programm erkennt und verarbeitet also die Navigationsdaten in der oben beschriebenen Form und ist in der Lage, durch ein dem Interleaving komplementäres De-Interleaving wieder die ursprünglichen Navigationsdatenblocks zu rekonstruieren.

Ein weiterer Gegenstand der vorliegenden Erfindung ist ein Computer-Programm-Produkt beinhaltend einen maschinenlesbaren Programmträger, auf dem ein vorgenanntes Computer-Programm in Form von elektronisch auslesbaren Steuersignalen gespeichert ist, wobei das Computer-Programm-Produkt zum Zusammenwirken mit einem Teilnehmer-Endgerät ausgebildet ist. Die Steuersignale können in jeder geeigneten Form gespeichert sein, die elektronische Auslesung kann dann entsprechend durch elektrische, magnetische, elektromagnetische, elektrooptische oder sonstige elektronische Verfahren erfolgen. Beispiele für solche Programmträger sind Magnetbänder, Disketten, Festplatten, CD-ROM oder Halbleiterbausteine.

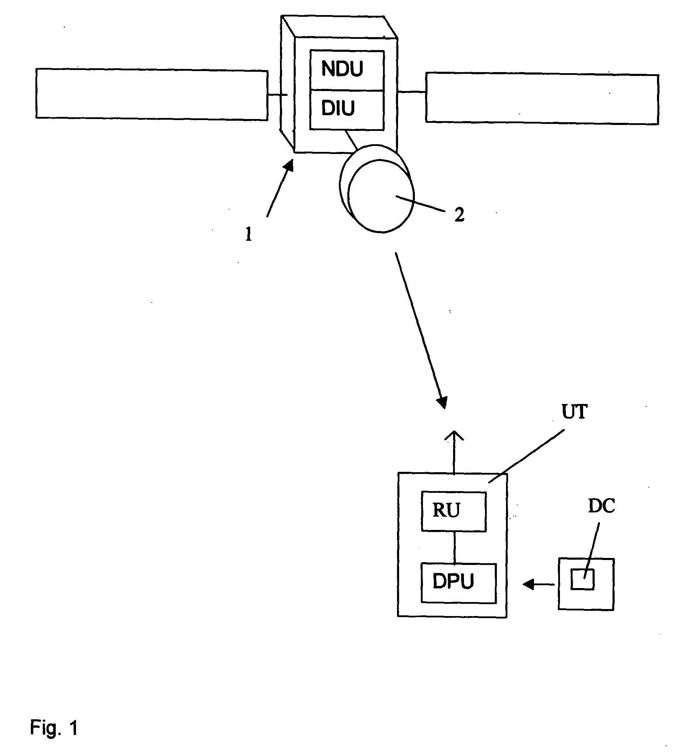

Nachfolgend wird ein spezielles Ausführungsbeispiel anhand der Figur 1 und der Tabellen 1 und 2 erläutert.

Es zeigt:

**Fig. 1:**   Schematische Darstellung eines Satelliten-Navigationssystems

**Tab. 1 und 2:**   Schematische Darstellung der Aufteilung von Navigations-Datenblocks auf Datenpakete

In Fig. 1 ist schematisch ein Satelliten-Navigationssystem dargestellt. Ein Navigationssatellit 1 weist eine Einrichtung NDU (Navigation Data Unit) zur Bereitstellung von Navigationsdatenblocks auf. Es sollen hier zwei Arten von Navigationsdatenblocks betrachtet werden: Navigationsnachrichten und Integritätsnachrichten. Dies wird anhand der Tabellen detaillierter erläutert. Der Navigationssatellit 1 weist weiter eine Einrichtung DIU (Data Interleaving Unit) zum Interleaving von Navigationsdatenblocks auf. Dieses Interleaving der Navigationsdatenblocks erfolgt, bevor eine Übertragung der Daten an ein Teilnehmer-Endgerät UT (User Terminal) erfolgt. Zur Übertragung der Daten weist der Navigationssatellit 1 eine Übertragungseinrichtung 2 auf. Das Teilnehmer-Endgerät UT weist eine Empfangseinrichtung RU (Receive Unit) und eine Einrichtung DPU (Data Processing Unit) zur Rekonstruktion von Navigationsdatenblocks aus den empfangenen Daten auf.

Es seien nun als Beispiel für Navigationsdatenblocks folgende Beispiele betrachtet:

- eine Navigationsnachricht N mit einer Länge von 96 Dateneinheiten bzw. Symbolen B1, B2, B3, B4....., B96, die Daten enthalten, aufgrund derer ein Endgerät UT unmittelbar seine Position bestimmen kann,
- eine Integritätsnachricht A mit einer Länge von 12 oder 24 Dateneinheiten bzw. Symbolen A1, A2, A3, ... A12 bzw. A1, A2, A3, ... A24
- eine Integritätsnachricht B mit einer Länge von 12 oder 24 Dateneinheiten bzw. Symbolen B1, B2, B3, ..., B12 bzw. B1, B2, B3, ..., B24

Statt Integritätsnachrichten können natürlich auch andere geeignete Arten von zeitkritischen Statusnachrichten vorgesehen werden.

Die Übertragung von Integritätsnachrichten in Satelliten-Navigationssystemen ist deutlich zeitkritischer als die Übertragung von Navigationsnachrichten, deren Inhalt sich zeitlich nur langsam ändert. Außerdem sind die Integritätsnachrichten deutlich kürzer als die Navigationsnachrichten.

Jede der drei Nachrichten N, A, B bildet einen Navigationsdatenblock. Die einzelnen Dateneinheiten der Navigationsdatenblocks werden durch die Einrichtung DIU zum Interleaving auf Pakete a, b, c, ... der Länge l=12 aufgeteilt, wie die Tabellen 1 und 2 veranschaulichen. Die Pakete a, b, c, ... sind hier in Form von Spalten dargestellt. Das Interleaving erfolgt durch eine Übertragung der Dateneinheiten in Zeilenrichtung der Tabelle 1 bzw. der Tabelle 2. Es wird also ein Interleaving realisiert, indem zunächst nacheinander alle Dateneinheiten übertragen werden, deren Datenadresse den niedrigsten Index aufweist, also a0, b0, c0, d0, ... Danach erfolgt die Übertragung der nächsten Reihe a1, b1, c1, d1, ... und so weiter bis zur Übertragung der letzten Reihe a11, b11, c11, d11, .... Wie man leicht erkennt, werden dadurch die einzelnen Dateneinheiten der einzelnen Navigationsdatenblocks voneinander separiert übertragen. In den Tabellen 1 und 2 beträgt die Separierung m=8 Dateneinheiten für die Daten der Integritätsnachrichten.

Wie man ebenfalls aus den Tabellen 1 und 2 erkennt, werden nicht alle Pakete gleichermaßen mit Daten beliebiger Navigationsdatenblocks gefüllt. Ein Teil der Pakete, nämlich im Fall der Tabelle 1 die Pakete c, f, i, l und im Fall der Tabelle 2 die Pakete c, h, sind für Daten der Integritätsnachrichten A, B reserviert, die übrigen Pakete sind für Daten der Navigationsnachricht N reserviert. Die Zahl der für Integritätsnachrichten reservierten Pakete wird über das Verhältnis der Datenmenge der Integritätsnachrichten zur Datenmenge der Navigationsnachricht definiert.

Besitzen die Nachrichten A, B eine Länge von 12 Dateneinheiten, so ist das Verhältnis 2*12 : 96 = 1 : 4 d.h. dass das Verhältnis

Zahl der Pakete für Integritätsnachrichten/Zahl der Pakete für Navigationsnachricht ebenfalls gleich 1 : 4 gewählt wird, wie Tabelle 2 zeigt.

Besitzen die Nachrichten A, B eine Länge von 24 Dateneinheiten, so ist das Verhältnis 2*24 : 96 = 1 : 2 d.h. dass das Verhältnis

Zahl der Pakete für Integritätsnachrichten/Zahl der Pakete für Navigationsnachricht ebenfalls gleich 1 : 2 gewählt wird, wie Tabelle 1 zeigt.

Die Pakete, die für die Navigationsnachricht reserviert sind, werden fortlaufend mit Dateneinheiten N1, N2, N3, .... der Navigationsnachricht N aufgefüllt. Ist ein Paket a komplett gefüllt, so wird mit dem nächsten Paket b weitergemacht, bis alle Pakete, die für die Navigationsnachricht N reserviert sind, mit Daten der Navigationsnachricht N gefüllt sind.

Die Pakete, die für die Integritätsnachrichten A, B reserviert sind, werden jedoch anders gefüllt: Jedes Paket wird nur mit n/k Dateneinheiten gefüllt, wobei n die Länge des Pakets und k eine ganze Zahl k=2, 3, 4 darstellt. Insbesondere kann k die Zahl der im Rahmen der aktuellen Pakete zu übertragenden Integritätsnachrichten darstellen, hier also k=2. Folglich wird jedes entsprechend reservierte Paket nur mit 12/2 = 6 Dateneinheiten einer Integritätsnachricht, beginnend vom Anfang c0 des Pakets c, aufgefüllt. Sind die reservierten Pakete mit den Daten der Integritätsnachricht A zur Hälfte gefüllt, dann wird die verbleibende Hälfte mit den Daten der Integritätsnachricht B gefüllt, beginnend bei Datenadresse c6.

Anschließend erfolgt für die Datenübertragung ein Interleaving über alle Pakete a, b, c, d, ... wie bereits oben beschrieben. Ein Vorteil des hier beschriebenen Verfahrens ist, dass die Integritätsnachricht A bereits nach der Hälfte der Zeit komplett vom Endgerät UT empfangen werden kann, die benötigt wird, um alle Pakete a, b, c... komplett zu übertragen. Dies wird durch die hier beschriebene Aufteilung der Integritätsnachrichten auf die Pakete und die anschließende zeilenweise Übertragung der Pakete möglich, da bereits nach Übertragung der ersten sechs Zeilen mit den Indizes 0, 1, 2, 3, 4, 5 die Integritätsnachricht komplett übertragen ist.

Damit wird garantiert, dass gerade zeitkritische Daten so schnell wie möglich zum Endgerät UT übertragen werden und trotzdem ein Interleaving mit ausreichender Separierung erfolgt.

Tabelle 1 für $m = 8$, $n = 12$, $k = 2$ and $l = 24$:

|    | a   | b   | c  | d   | e   | f   | g   | h   | i   | j   | k   | l   |
|----|-----|-----|----|-----|-----|-----|-----|-----|-----|-----|-----|-----|
| 11 | N12 | N24 | B6 | N36 | N48 | B12 | N60 | N72 | B18 | N84 | N96 | B24 |
| 10 | N11 | N23 | B5 | N35 | N47 | B11 | N59 | N71 | B17 | N83 | N95 | B23 |
| 9  | N10 | N22 | B4 | N34 | N46 | B10 | N58 | N70 | B16 | N82 | N94 | B22 |
| 8  | N9  | N21 | B3 | N33 | N45 | B9  | N57 | N69 | B15 | N81 | N93 | B21 |
| 7  | N8  | N20 | B2 | N32 | N44 | B8  | N56 | N68 | B14 | N80 | N92 | B20 |
| 6  | N7  | N19 | B1 | N31 | N43 | B7  | N55 | N67 | B13 | N79 | N91 | B19 |
| 5  | N6  | N18 | A6 | N30 | N42 | A12 | N54 | N66 | A18 | N78 | N90 | A24 |
| 4  | N5  | N17 | A5 | N29 | N41 | A11 | N53 | N65 | A17 | N77 | N89 | A23 |
| 3  | N4  | N16 | A4 | N28 | N40 | A10 | N52 | N64 | A16 | N76 | N88 | A22 |
| 2  | N3  | N15 | A3 | N27 | N39 | A9  | N51 | N63 | A15 | N75 | N87 | A21 |
| 1  | N2  | N14 | A2 | N26 | N38 | A8  | N50 | N62 | A14 | N74 | N86 | A20 |
| 0  | N1  | N13 | A1 | N25 | N37 | A7  | N49 | N61 | A13 | N73 | N85 | A19 |

Tabelle 2 für $m = 8$, $n = 12$, $k = 2$ and $l = 12$:

|     | a   | b   | c   | d   | e   | f   | g   | h   | i   | j   |
| --- | --- | --- | --- | --- | --- | --- | --- | --- | --- | --- |
| 11  | N12 | N24 | B6  | N36 | N48 | N60 | N72 | B12 | N84 | N96 |
| 10  | N11 | N23 | B5  | N35 | N47 | N59 | N71 | B11 | N83 | N95 |
| 9   | N10 | N22 | B4  | N34 | N46 | N58 | N70 | B10 | N82 | N94 |
| 8   | N9  | N21 | B3  | N33 | N45 | N57 | N69 | B9  | N81 | N93 |
| 7   | N8  | N20 | B2  | N32 | N44 | N56 | N68 | B8  | N80 | N92 |
| 6   | N7  | N19 | B1  | N31 | N43 | N55 | N67 | B7  | N79 | N91 |
| 5   | N6  | N18 | A6  | N30 | N42 | N54 | N66 | A12 | N78 | N90 |
| 4   | N5  | N17 | A5  | N29 | N41 | N53 | N65 | A11 | N77 | N89 |
| 3   | N4  | N16 | A4  | N28 | N40 | N52 | N64 | A10 | N76 | N88 |
| 2   | N3  | N15 | A3  | N27 | N39 | N51 | N63 | A9  | N75 | N87 |
| 1   | N2  | N14 | A2  | N26 | N38 | N50 | N62 | A8  | N74 | N86 |
| 0   | N1  | N13 | A1  | N25 | N37 | N49 | N61 | A7  | N73 | N85 |

Diese spezielle Klasse von Beispielen kann in allgemeiner Form wie folgt dargestellt werden: Angenommen, es soll eine Navigationsnachricht, also eine lange Nachricht mit einer Länge von $n \times m$ Dateneinheiten bzw. Symbolen einmal pro Sekunde übertragen werden und es sollen $k$ Integritätsnachrichten, also kurze Nachrichten, mit einer Länge von $l$ Dateneinheiten bzw. Symbolen pro Sekunde übertragen werden Wenn man ganze Zahlen $i$, $j$ und $p$ finden kann, so dass gilt: $k \times l = i \times n$, $k \times j = n$ und $m = i \times (p-1)$, dann kann in jedem Fall eine Aufteilung der Navigationsdaten auf Pakete erfolgen, wie sie beispielhaft in den Tabellen 1 und 2 gezeigt wurde.

Es kann dann ein Interleaving der Matrix erfolgen, die durch die Pakete gebildet wird und die

$$\left( \frac{k \times l}{n} + m \right)$$

spalten und $n$ Zeilen besitzt, wobei jede $\frac{m \times n}{k \times l}$-te Spalte für Integritätsnachrichten, also für kurze Nachrichten reserviert ist.

Die $m$ Spalten bzw. Pakete, die für die Daten der Navigationsnachricht (also für die lange Nachricht) reserviert sind, werden Spalte für Spalte und damit Paket für Paket mit Daten gefüllt. Dagegen wird beim Auffüllen der für Integritätsnachrichten (also für kurze Nachrichten) reservierten Spalten bzw. Pakete nach jedem $\frac{n}{k}$-ten Symbol die Spalte gewechselt wird. Es wird dann Zeile für Zeile der Matrix an die Endgeräte UT übertragen, wodurch die Gesamtheit der Daten gesendet wird und gleichzeitig ein Interleaving erfolgt.

Damit ergibt sich folgendes:

1. Eine lange Nachricht kann im Endgerät UT komplett de-interleaved werden, nachdem $k \times l + m \times n$ Symbole empfangen wurden.

2. Eine kurze Nachricht kann jedoch bereits komplett de-interleaved werden, nachdem $l + \frac{m \times n}{k}$ Symbole vom Endgerät empfangen wurden.

3. Die Separierung aufeinanderfolgender Symbole der kurzen Nachricht beträgt min

$$\left(\frac{k \times l}{n} + m, \frac{n}{k} + \frac{m \times n}{k \times l}\right)$$

Symbole.

4. Die Separierung aufeinanderfolgender Symbole der langen Nachricht beträgt n Symbole.

Ein Vorteil dieses Verfahrens ist damit, dass die kurzen Nachrichten *k* Mal pro Sekunde komplett de-interleaved werden können und trotzdem eine ausreichende Separierung zwischen aufeinanderfolgenden Symbolen der kurzen Nachrichten gegeben ist.

Sofern keine ganzen Zahlen *i*, *j* und *p* gefunden werden können, für die $k \times l = i \times n$, $k \times j = n$ und $m = i \times (p-1)$ gilt, kann grundsätzlich das gleiche Verfahren wie oben durchgeführt werden, aber dann werden

$$\left(\text{int}\left(\frac{k \times l}{n}\right) + 1 + m\right)$$

Spalten bzw. Pakete benötigt, wenn weiterhin eine möglichst gleichmäßige und ausreichende Separierung zwischen aufeinanderfolgenden Symbolen der kurzen Nachrichten gegeben sein soll. Es kann dann auch vorgesehen werden, dass einzelne Datenadressen der Pakete bzw. Spalten mit Füll-Dateneinheiten wie Füllbits aufgefüllt werden, um wieder eine komplette Füllung einer ganzen Matrix mit Daten analog zu den Tabellen 1 und 2 zu erzielen und so Abweichungen der Länge der Nachrichten von der gewünschten Länge analog Tabellen 1 und 2 auszugleichen.

Betrachtet man nun noch das Teilnehmer-Endgerät UT, so kann dieses insbesondere mit Hilfe eines Computer-Programms zur Verarbeitung der empfangenen Daten zur Rekonstruktion der Navigationsdatenblocks des Satelliten-Navigationssystems eingerichtet werden, wenn die sonstigen Hardware-Voraussetzungen in dem Teilnehmer-Endgerät UT gegeben sind. Das Computer-Programm ermöglicht dann insbesondere im Zusammenwirken mit der Datenverarbeitungseinrichtung DPU das Erkennen und Verarbeiten der Datenpakete von Integritätsnachrichten A, B und von Navigationsnachrichten N. Mit Hilfe des Computer-Programms können aus den empfangenen Daten, die ein Interleaving durchlaufen haben, durch ein komplementäres De-Interleaving die ursprünglichen Integritätsnachrichten A, B und Navigationsnachrichten N wieder hergestellt werden.

Das Computer-Programm kann bevorzugt mit Hilfe eines Computer-Programm-Produktes in das Teilnehmer-Endgerät UT eingebracht werden, wobei das Computer-Programm-Produkt einen maschinenlesbaren Programmträger (Data Carrier) DC beinhaltet, auf dem das Computer-Programm in Form von elektronisch auslesbaren Steuersignalen gespeichert ist. Ein Beispiel wäre eine Chipkarte mit einem Halbleiterchip, in dem das Computerprogramm gespeichert ist. Es sind aber auch alle anderen geeigneten Arten von Computer-Programm-Produkten anwendbar.

## Patentansprüche

1. Verfahren zur Bereitstellung und Übertragung von Navigationsdaten in einem Navigationssystem durch Übertragung von mehreren Navigationsdatenblocks von einer Navigationsdaten-Sendeeinrichtung an Navigations-Endgeräte, **dadurch gekennzeichnet, dass** vor der Übertragung der Navigationsdaten an die Navigations-Endgeräte ein Interleaving von mindestens zwei Navigationsdatenblocks erfolgt.

2. Verfahren nach Anspruch 1, **dadurch gekennzeichnet, dass** zum Interleaving für jede Dateneinheit der Navigationsdatenblocks mit Hilfe eines Algorithmus ein Sendezeitpunkt festgelegt wird, wobei die Abfolge der Sendezeitpunkte von der ursprünglichen Abfolge der Dateneinheiten innerhalb der Navigationsdatenblocks abweicht.

3. Verfahren nach Anspruch 2, **dadurch gekennzeichnet, dass** der Algorithmus derart ausgebildet ist, dass zur Übertragung von k zeitkritischen Navigationsdatenblocks mit k= 2, 3, 4, ... und eines zeitunkritischen Navigationsdatenblocks die Sendezeitpunkte der Dateneinheiten eines jeden zeitkritischen Navigationsdatenblocks jeweils in einem Bruchteil 1/k der Sendezeit des zeitunkritischen Navigationsdatenblocks festgelegt werden.

4. Verfahren nach einem der Ansprüche 1 bis 4, **dadurch gekennzeichnet, dass** die Navigationsdatenblocks in gleiche Pakete mit indizierten Datenadressen aufgeteilt werden und ein Interleaving durch aufeinanderfolgende Übertragung jeweils einer Dateneinheit eines Paketes erfolgt.

5. Verfahren nach Anspruch 4, **dadurch gekennzeichnet, dass** zunächst nacheinander die Dateneinheiten aller Pakete mit der niedrigsten oder höchsten Datenadresse gesendet werden und dann die nacheinander die Dateneinheiten aller Pakete mit der nächsthöheren oder nächstniedrigeren Datenadresse gesendet werden.

6. Verfahren nach Anspruch 4 oder 5, **dadurch gekennzeichnet, dass** mindestens eine erste Gruppe von Paketen für Navigationsdatenblocks mit zeitkritischen Navigationsdaten reserviert wird und mindestens eine zweite Gruppe von Paketen für Navigationsdatenblocks mit zeitunkritischen Navigationsdaten reserviert wird.

7. Verfahren nach einem der Ansprüche 3 bis 6, **dadurch gekennzeichnet, dass** als zeitkritische Daten Statusnachrichten übertragen werden und als zeitunkritische Navigationsdaten Navigations-Nutzdaten übertragen werden.

8. Verfahren nach Anspruch 7, **dadurch gekennzeichnet, dass** als Statusnachrichten Integritätsnachrichten betreffend Navigationsdaten-Sendeeinrichtungen des Navigationssystems übertragen werden.

9. Verfahren nach Anspruch 8, **dadurch gekennzeichnet, dass** die Übertragung der Navigationsdaten durch einen Navigationssatelliten erfolgt und dass als Integritätsnachrichten Nachrichten über die eigene Integrität des übertragenden Navigationssatelliten, oder über die Integrität einer ausgewählten Gruppe von Navigationssatelliten oder über die Integrität aller Navigationssatelliten eines Satelliten-Navigationssystems übertragen werden, zu dem der übertragende Navigationssatellit gehört.

10. Verfahren nach Anspruch 8 oder 9, **dadurch gekennzeichnet, dass** alternativ oder zusätzlich als Integritätsnachrichten Nachrichten über die Integrität von Navigationssatelliten anderer Satelliten-Navigationssyteme übertragen werden.

11. Verfahren nach einem der Ansprüche 4 bis 10, **dadurch gekennzeichnet, dass**

   - alle Pakete eine Länge von n Dateneinheiten aufweisen,
   - Pakete der ersten Gruppe von Paketen mit n/k, k=2, 3, 4, 5... Dateneinheiten eines Navigationsdatenblocks zeitkritischer Daten gefüllt werden und
   - Pakete der zweiten Gruppe von Paketen mit n Dateneinheiten eines Navigationsdatenblocks zeitunkritischer Daten gefüllt werden.

12. Verfahren nach einem der Ansprüche 3 bis 11, **dadurch gekennzeichnet, dass** die Datenmenge der zeitkritischen Daten maximal die Hälfte der Datenmenge der zeitunkritischen Daten beträgt.

13. Verfahren nach Anspruch 12, **dadurch gekennzeichnet, dass** die Datenmenge der zeitkritischen Daten maximal ein Viertel der Datenmenge der zeitunkritischen Daten beträgt.

14. Satelliten-Navigationssystem mit Navigationssatelliten (1) mit Einrichtungen (NDU) zur Bereitstellung von Navigationsdaten in Form von mehreren Navigationsdatenblocks und Einrichtungen (2) zur Übertragung von Daten an Navigations-Endgeräte (UT), **dadurch gekennzeichnet, dass** jeder Navigationssatellit (1) eine Einrichtung (DIU) zum Interleaving von mindestens zwei Navigationsdatenblocks vor der Übertragung der Navigationsdaten an die Navigations-Endgeräte (UT) aufweist.

15. Satelliten-Navigationssystem nach Anspruch 14, **dadurch gekennzeichnet, dass** die Einrichtung (DIU) zum Interleaving nach einem Verfahren nach einem der Ansprüche 2 bis 13 ausgebildet ist.

16. Teilnehmer-Endgerät (UT) für ein Satelliten-Navigationssystem, aufweisend eine Einrichtung (DPU) zur Rekonstruktion von Navigationsdatenblocks, welche vom Teilnehmer-Endgerät durch eine Empfangseinrichtung (RU) von mindestens einem Navigationssatelliten (1) empfangen wurden und welche vor dem Empfang einem Interleaving nach einem Verfahren nach einem der Ansprüche 1 bis 13 unterzogen wurden.

17. Computer-Programm zur Verarbeitung von Navigationsdaten eines Satelliten-Navigationssystems, welche nach einem Verfahren nach einem der Ansprüche 1 bis 13 einem Interleaving unterzogen wurden, wobei das Computer-Programm für ein Zusammenwirken mit Einrichtungen (DPU) eines Teilnehmer-Endgerätes (UT) nach Anspruch 16 ausgebildet ist.

18. Computer-Programm-Produkt beinhaltend einen maschinenlesbaren Programmträger (DC), auf dem ein Computer-Programm nach Anspruch 17 in Form von elektronisch auslesbaren Steuersignalen gespeichert ist, wobei das Computer-Programm-Produkt zum Zusammenwirken mit einem Teilnehmer-Endgerät (UT) ausgebildet ist.

Fig. 1